# EUROPÄISCHE PATENTSCHRIFT

(11) **EP 0 618 756 B1**
(45) Veröffentlichungstag und Bekanntmachung des Hinweises auf die Patenterteilung: **29.10.1997**
(21) Anmeldenummer: 94200858.2
(22) Anmeldetag: 29.03.1994
(51) Int. Cl.: H05K 1/18, H01M 2/10

(54) **Gerät mit mindestens einer an einer Leitplatte fix angebrachten Batterie**
Apparatus having at least one battery secured to a printed circuit board
Dispositif avec au moins une batterie fixée à un panneau à circuit imprimé

(30) Priorität: 01.04.1993 AT 673/93
(43) Veröffentlichungstag der Anmeldung: 05.10.1994
(73) Patentinhaber: Philips Electronics N.V., 5621 BA Eindhoven (NL)
(72) Erfinder: Krainer, Erich, Prof. Holstlaan 6, NL-5656 AA Eindhoven (NL); Sonnek, Martin, Prof. Holstlaan 6, NL-5656 AA Eindhoven (NL)
(74) Vertreter: Bos, Kornelis Sjoerd

(56) Entgegenhaltungen:
- EP-A- 0 432 331
- EP-A- 0 532 301

## Beschreibung

Die Erfindung bezieht sich auf ein Gerät mit einer Leiterplatte und mit mindestens einer an der Leiterplatte angebrachten, zur Energieversorgung des Gerätes vorgesehenen Batterie, die zwei Pole aufweist, die mit je einer Lötfahne versehen sind, die mit einem Trägerbereich der Leiterplatte mittels einer Lötverbindung fest verbunden ist, wobei die Trägerbereiche der Leiterplatte von der übrigen Leiterplatte wegbrechbar sind, um die mindestens eine Batterie aus dem Gerät entfernen zu können.

Ein Gerät gemäß der vorstehend im ersten Absatz angeführten Gattung ist beispielsweise aus der EP O 432 331 A2 bekannt, wobei bezüglich dieser EP O 432 331 A2 insbesondere auf die in den Figuren 29 bis 36 dargestellten Ausführungsbeispiele hinzuweisen ist, für die mit dem unabhängigen Anspruch 3 der EP O 432 331 A2 Schutz begehrt wird. Bei dem bekannten Gerät handelt es sich bei den Trägerbereichen der Leiterplatte um periphere Randbereiche der Leiterplatte, die in eine Randzone der Leiterplatte münden und von denen zumindest eine Begrenzungskante frei zugänglich liegt. Weiters ist bei dem bekannten Gerät in jedem Verbindungsabschnitt zwischen einem Trägerbereich und der übrigen Leiterplatte eine Bruchlinie ausgeformt, die hierbei beispielsweise durch rinnenartige Vertiefungen oder durch in Längsrichtung einer Bruchlinie aufeinanderfolgend angeordnete, die Leiterplatte im Bereich eines Verbindungsabschnittes durchsetzende längliche Schlitze oder durch in Längsrichtung einer Bruchlinie aufeinanderfolgend angeordnete, die Leiterplatte im Bereich eines Verbindungsabschnittes durchsetzende Löcher mit einem kreisförmigen Querschnitt gebildet ist.

Bei allen Ausführungsbeispielen des bekannten Gerätes ist es aufgrund der vorstehend beschriebenen Ausbildung möglich, die Trägerbereiche mit der Hand von der übrigen Leiterplatte wegzubrechen, wobei das manuelle Angreifen entweder direkt an den wegbrechbaren Trägerbereichen oder aber auch an der mit den Trägerbereichen verbundenen Batterie erfolgen kann. Nachteiligerweise kann aber bei allen Ausführungsbeispielen des bekannten Gerätes eine Batterie stets nur im Randbereich einer Leiterplatte an derselben angebracht werden, weil die zum Tragen der Batterie vorgesehenen Trägerbereiche nur im Randbereich einer Leiterplatte vorgesehen werden können, um sie manuell wegbrechen zu können. Hierdurch ist aber eine Einschränkung in der Wahlfreiheit der Anordnung einer Batterie an einer Leiterplatte gegeben, was insbesondere bei möglichst kompakt auszubildenden Geräten, wie etwa batteriebetriebenen Rasierapparaten, batteriebetriebenen Zahnbürsten, batteriebetriebenen Taschenrechnern und auch vielen anderen kleinen batteriebetriebenen Geräten, nachteilig ist.

Die Erfindung hat sich zur Aufgabe gestellt, bei einem Gerät gemäß der im ersten Absatz angefuhrten Gattung die vorstehend angeführten Schwierigkeiten zu beseitigen und auf einfache Weise die Möglichkeit zu schaffen, eine Batterie in jeder beliebigen räumlichen Anordnung ohne Einschränkung hinsichtlich der Position der Batterie an einer Leiterplatte anbringen und bei in jeder solchen beliebigen Anordnung angebrachter Batterie die Trägerbereiche der Leiterplatte von der übrigen Leiterplatte auf einfache Weise wegbrechen zu können. Hierfür ist die Erfindung dadurch gekennzeichnet, daß jeder Trägerbereich der Leiterplatte von der übrigen Leiterplatte ringsum umgeben ist und daß zwischen jedem Trägerbereich und der übrigen Leiterplatte ein den betreffenden Trägerbereich teilweise umschließender Durchbruch vorgesehen ist und daß jeder Trägerbereich über einen zwischen den beiden Enden jedes Durchbruches liegenden Verbindungsabschnitt der Leiterplatte mit der übrigen Leiterplatte verbunden ist, wobei jeder innerhalb eines Durchbruches liegende Trägerbereich im wesentlichen im Bereich eines Verbindungsabschnittes von der übrigen Leiterplatte, vorzugsweise mit Hilfe eines Werkzeuges, wegbrechbar ist.

Auf diese Weise ist erreicht, daß eine Batterie in jeder beliebigen Anordnung an einer Leiterplatte angebracht werden kann, also auch in einer solchen Anordnung, daß beide Trägerbereiche für eine Batterie in einem zentralen Bereich einer Leiterplatte liegen,
und daß bei in jeder solchen beliebigen Anordnung angebrachter Batterie die Trägerbereiche der Leiterplatte von der übrigen Leiterplatte auf einfache Weise weggebrochen werden können, um die Batterie aus dem Gerät entfernen zu können.

Bei der erfindungsgemäßen Ausbildung ist es auch nicht erforderlich, eine separate Bruchlinie im Verbindungsabschnitt zwischen einem Trägerbereich und der übrigen Leiterplatte vorzusehen, da das Wegbrechen jedes Trägerbereiches aufgrund der Ausbildung des den Trägerbereich teilweise umschließenden Durchbruches stets zwischen den beiden Enden des Durchbruches im Bereich des dort liegenden Verbindungsabschnittes erfolgt, wobei es aber vollkommen unerheblich ist, welchen Verlauf die jeweilige Bruchzone aufweist.

Jeder Durchbruch kann in Relation zu einer Batterie, deren Lötfahne mit dem vom Durchbruch umgebenen Trägerbereich verbunden ist, jede beliebige Lage einnehmen. Als besonders vorteilhaft hat sich aber erwiesen, wenn jeder Durchbruch im wesentlichen quer zur Längserstreckung einer Batterie ausgerichtet ist und je die beiden Enden von zwei Durchbrüchen einander zugewandt sind, die zwei Trägerbereiche teilweise begrenzen, mit denen die beiden Lötfahnen einer Batterie mittels je einer Lötverbindung fest verbunden sind. Dies hat sich in der Praxis als besonders günstig erwiesen, weil dadurch ein besonders leichtes und rasches Entfernen einer Batterie von einer Leiterplatte und folglich aus einem Gerät ermöglicht wird.

Jeder der Durchbrüche kann beispielsweise im wesentlichen V-förmig ausgebildet sein. Als vorteilhaft hat sich erwiesen, wenn jeder Durchbruch im wesentlichen C-förmig ausgebildet ist, weil sich in der Praxis ergeben hat, daß eine solche Ausbildung besonders günstig ist.

Jeder im wesentlichen C-förmige Durchbruch kann beispielsweise einen ovalartigen, kreisartigen oder auch andersartigen Verlauf aufweisen. Als besonders vorteilhaft hat sich aber erwiesen, wenn jeder Trägerbereich rechteckförmig ausgebildet ist und jeder Durchbruch aus geradlinig verlaufenden Durchbruchsabschnitten besteht.

Dies ist im Hinblick auf ein möglichst einfaches und gutes Anlöten der Lötfahnen an den Trägerbereichen vorteilhaft.

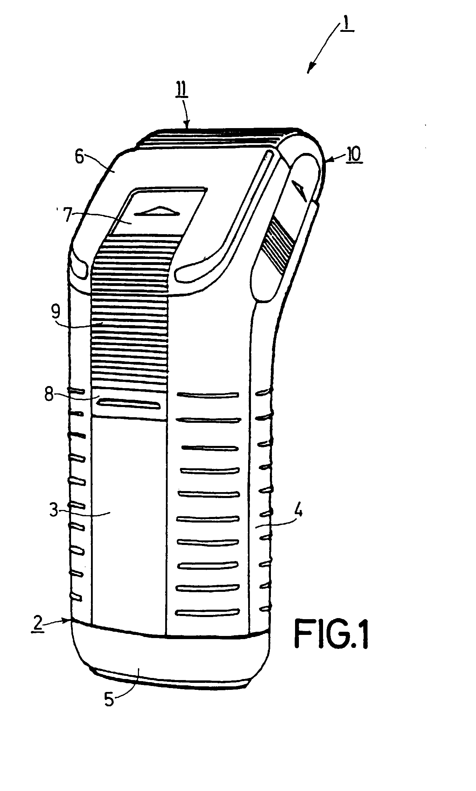

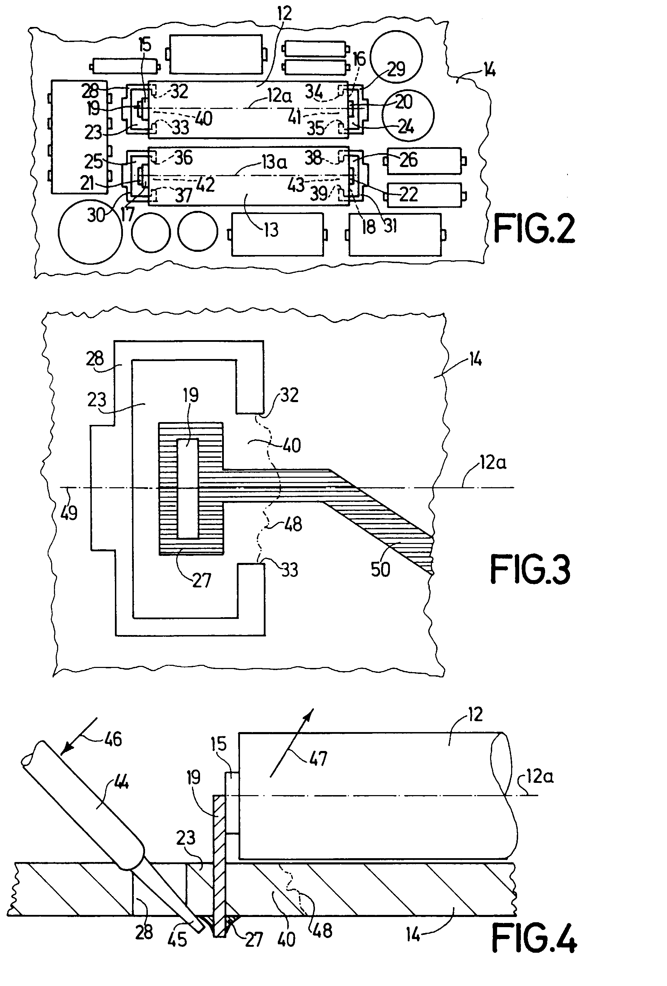

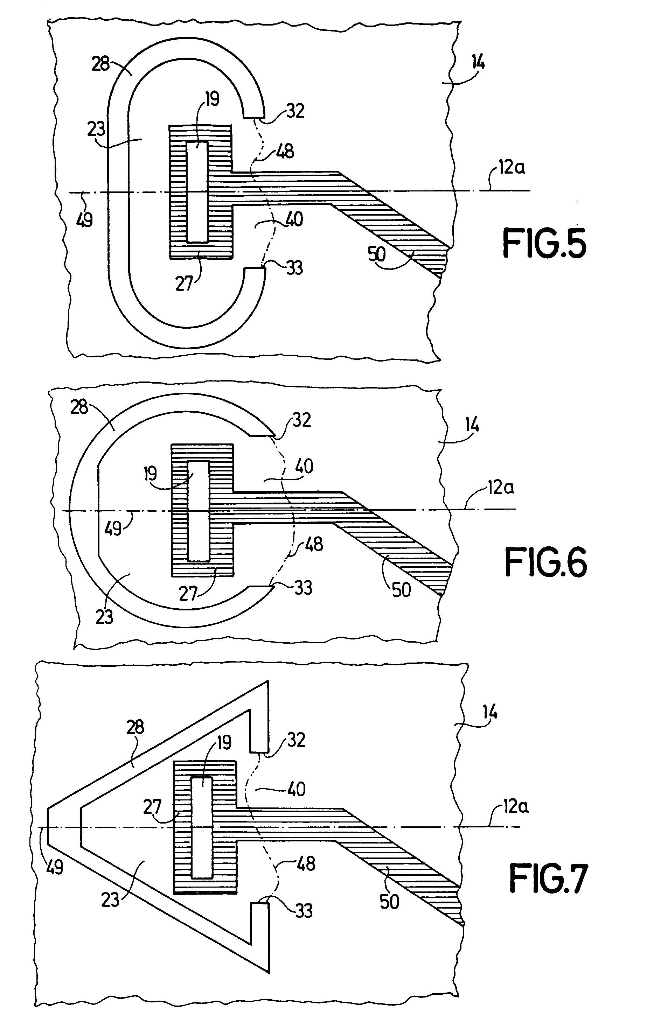

Die Erfindung wird im folgenden anhand von mehreren in den Zeichnungen dargestellten Ausführungsbeispielen näher beschrieben, auf die die Erfindung jedoch nicht beschränkt sein soll. Die Fig. 1 zeigt in einer Schrägansicht ein Gerät gemaß einem ersten Ausführungsbeispiel der Erfindung, nämlich einen Rasierapparat, der eine Kurzhaar-Schneideinrichtung und eine Langhaar-Schneideinrichtung aufweist, wobei die antreibbaren Messer der beiden Schneideinrichtungen von einem Motor her antreibbar sind, der aus zwei fix an einer Leiterplatte des Rasierapparates angebrachten Batterien mit elektrischer Energie versorgbar ist. Die Fig. 2 zeigt teilweise die in dem Rasierapparat gemäß Fig. 1 untergebrachte Leiterplatte, an der die beiden Batterien zum Speisen des Motors des Rasierapparates gemäß Fig. 1 fix angebracht sind. Die Fig. 3 zeigt in einem gegenüber der Fig. 2 größeren Maßstab in einer Ansicht von unten ein Detail der Leiterplatte gemäß Fig. 2, aus dem die Ausbildung eines im wesentlichen rechteckigen Trägerbereiches für eine von einem Pol einer Batterie abstehende Lötfahne und die Ausbildung eines den Trägerbereich teilweise umschließenden im wesentlichen C-förmigen Durchbruches ersichtlich ist. Die Fig. 4 zeigt in einem gegenüber der Fig. 2 größeren Maßstab in einem Querschnitt ein Detail der Leiterplatte gemäß den Figuren 2 und 3, aus dem die Befestigung einer Lötfahne an einem Trägerbereich für dieselbe und die Art und Weise, wie dieser Trägerbereich von der übrigen Leiterplatte wegbrechbar ist, ersichtlich ist. Die Fig. 5 zeigt analog wie die Fig. 3 ein Detail einer Leiterplatte eines Gerätes gemäß einem zweiten Ausführungsbeispiel der Erfindung, aus dem die Ausbildung eines im wesentlichen ovalen Trägerbereiches für eine Lötfahne und die Ausbildung eines den Trägerbereich teilweise umschließenden im wesentlichen ovalringsektorförmigen Durchbruches ersichtlich ist. Die Fig. 6 zeigt analog wie die Figuren 3 und 5 ein Detail einer Leiterplatte eines Gerätes gemäß einem dritten Ausführungsbeispiel der Erfindung, aus dem die Ausbildung eines im wesentlichen kreisförmigen Trägerbereiches für eine Lötfahne und die Ausbildung eines den Trägerbereich teilweise umschließenden im wesentlichen kreisringsektorförmigen Durchbruches ersichtlich ist. Die Fig. 7 zeigt analog wie die Figuren 3, 5 und 6 ein Detail einer Leiterplatte eines Gerätes gemäß einem vierten Ausführungsbeispiel, aus dem die Ausbildung eines im wesentlichen trapezförmigen Trägerbereiches für eine Lötfahne und die Ausbildung eines den Trägerbereich teilweise umschließenden im wesentlichen trapezartigen Durchbruches ersichtlich ist.

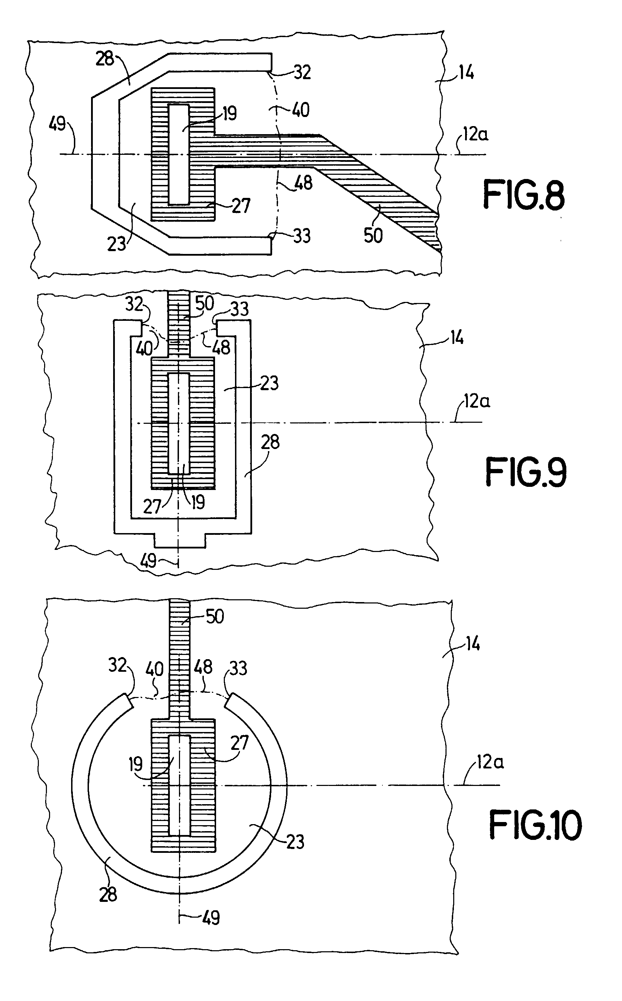

Die Fig. 8 zeigt analog wie die Figuren 3, 5, 6 und 7 ein Detail einer Leiterplatte eines Gerätes gemäß einem fünften Ausführungsbeispiel der Erfindung, aus dem die Ausbildung eines im wesentlichen sechseckigen Trägerbereiches für eine Lötfahne und die Ausbildung eines den Trägerbereich teilweise umschließenden im wesentlichen U-förmigen Durchbruches ersichtlich ist. Die Fig. 9 zeigt ein Detail einer Leiterplatte eines Gerätes gemäß einem sechsten Ausführungsbeispiel der Erfindung, aus dem die Ausbildung eines im wesentlichen rechteckigen Trägerbereiches für eine Lötfahne und die Ausbildung eines den Trägerbereich teilweise umschließenden im wesentlichen C-förmigen Durchbruches ersichtlich ist, wobei eine Symmetrielinie des Trägerbereiches und des Durchbruches im wesentlichen senkrecht zur Längsachse einer Batterie verläuft. Die Fig. 10 zeigt analog wie die Figuren 3, 5, 6, 7, 8 und 9 ein Detail einer Leiterplatte eines Gerätes gemäß einem siebenten Ausführungsbeispiel der Erfindung, aus dem die Ausbildung eines im wesentlichen kreisförmigen Trägerbereiches für eine Lötfahne und die Ausbildung eines den Trägerbereich teilweise umschließenden kreisringsektorförmigen Durchbruches ersichtlich ist, wobei eine Symmetrielinie des Trägerbereiches und des Durchbruches senkrecht zur Längsachse einer Batterie verläuft.

Die Fig. 1 zeigt ein Gerät gemäß einem ersten Ausführungsbeispiel der Erfindung, und zwar einen Rasierapparat 1, der ein Gehäuse 2 aufweist, das aus zwei miteinander verbundenen Gehäusehälften 3 und 4 besteht, die bodenseitig mit einem wannenförmigen Gehäuseteil 5 abgeschlossen sind. Im Bereich der Gehäusehälfte 3 ist ein in Fig. 1 nicht sichtbarer Seitenschneider vorgesehen, der zwischen einer in den Rasierapparat 1 zurückgezogenen Ruheposition und einer aus dem Rasierapparat 1 herausgeschobenen Betriebsposition verstellbar ist und der in seiner Ruheposition mit einer Abdeckplatte 6 abgedeckt ist, so daß nur ein Messerträger 7 des Seitenschneiders teilweise sichtbar ist. Zum Verstellen des in Fig. 1 nicht sichtbaren Seitenschneiders weist der Rasierapparat 1 eine Handhabe 8 auf, die über einen rolladenartigen flexiblen Verbindungsteil 9 mit dem Messerträger 7 des Seitenschneiders verbunden ist.

Auf das Gehäuse 2 des Rasierapparates 1 ist ein Scherkopf 10 aufgesetzt und daran festgehalten, der mit dem Gehäuse 2 lösbar verbunden ist. Der Scherkopf 10 weist ein folienartiges Obermesser auf, das mit Hilfe einer ebenfalls rolladenartigen Abdeckung 11 abdeckbar ist, die im wesentlichen parallel zur Hauptwand der Gehäusehälfte 4 zwischen einer in der Fig. 1 dargestellten Abdeckposition, in der sie das folienartige Obermesser schützend überdeckt, und einer Freigabeposition verstellbar ist, in der sie das folienartige Obermesser freigibt, um einen Rasierbetrieb zu ermöglichen.

Zum Antreiben eines mit dem folienartigen Obermesser zusammenwirkenden Untermessers und und zum Antreiben eines antreibbaren Messers des Seitenschneiders des Rasierapparates 1 weist der Rasierapparat 1 einen innerhalb des Gehäuses 2 untergebrachten Antriebsmotor auf. Zur Energieversorgung dieses Antriebsmotors sind innerhalb des Gerätegehäuses 2 zwei wiederaufladbare Batterien 12 und 13 vorgesehen.

Wie aus Fig. 2 ersichtlich ist, sind die beiden wiederaufladbaren Batterien 12 und 13 an einer Leiterplatte 14 fix angebracht, die im Gerätegehäuse 2 festgehalten ist. Neben den beiden Batterien 12 und 13 sind an der Leiterplatte 14 noch weitere Bauteile angebracht, die der Einfachheit halber ohne Bezugszeichen belassen sind. Von den beiden Batterien 12 und 13 sind deren Längsachsen mit den Bezugszeichen 12a und 13a bezeichnet.

Jede der beiden Batterien 12 und 13 weist zwei Pole 15 und 16 bzw. 17 und 18 auf. Jeder dieser Pole 15, 16, 17 und 18 ist mit je einer Lötfahne 19, 20, 21 bzw. 22 versehen. Jede der Lötfahnen 19, 20, 21 und 22 ist mit einem Trägerbereich 23, 24 , 25 bzw . 26 der Leiterplatte 1 4 mittels einer Lötverbindung 27, wie dies für die Lötfahne 19 in Fig. 4 dargestellt ist, fest verbunden. Die Trägerbereiche 23, 24, 25 und 26 der Leiterplatte 14 sind von der übrigen Leiterplatte 14 wegbrechbar, um die beiden Batterien 12 und 13 aus dem Rasierapparat 1 entfernen zu können.

Hierbei ist nunmehr bei dem Rasierapparat 1 gemaß Fig. 1 vorgesehen, daß jeder Trägerbereich 23, 24, 25 bzw. 26 der Leiterplatte 14 von der übrigen Leiterplatte 14 ringsum umgeben ist und daß zwischen jedem Trägerbereich 23, 24, 25 bzw. 26 und der übrigen Leiterplatte 14 ein den betref fenden Trägerbereich 23, 24, 25 bzw. 26 teilweise umschliessender schlitzartiger Durchbruch 28, 29, 30 bzw. 31 vorgesehen ist und daß jeder Trägerbereich 23, 24, 25 bzw. 26 über einen zwischen den beiden Enden 32, 33 bzw. 34, 35 bzw. 36, 37 bzw. 38, 39 jedes Durchbruches 28, 29, 30 bzw . 31 liegenden Verbindungsabschnitt 40 , 41, 42 bzw . 43 der Leiterplatte 14 mit der übrigen Leiterplatte 14 verbunden ist, wobei jeder innerhalb eines Durchbruches 28, 29 , 30 bzw. 31 liegende Trägerbereich 23, 24, 25 bzw. 26 im wesentlichem im Bereich eines Verbindungsabschnittes 40 , 41, 42 bzw. 43 von der ubrigen Leiterplatte 14, vorzugsweise mit Hilfe eines Werkzeuges 44, wegbrechbar ist.

Als Werkzeug 44 zum Wegbrechen eines Trägerbereiches 23, 24, 25 bzw. 26 kann beispielsweise ein Schraubenzieher 44 verwendet werden, der mit seinem freien Ende 45 durch einen Durchbruch 28, 29, 30 bzw. 31 hindurchgeführt wird, wie dies in Fig. 4 für den Durchbruch 28 dargestellt ist. Durch Niederdrücken des Schraubenziehers 44 in Richtung eines Pfeiles 46 wird der Trägerbereich 23 in Richtung eines Pfeiles 47 von der übrigen Leiterplatte 14 weggebrochen. Das Wegbrechen jedes Trägerbereiches 23, 24, 25 bzw. 26 erfolgt aufgrund der Ausbildung des den Trägerbereich 23, 24, 25 bzw. 26 teilweise umschließenden Durchbruches 28, 29, 30 bzw. 31 stets im wesentlichen zwischen den beiden Enden 32, 33 bzw. 34, 35 bzw. 36, 37 bzw. 38, 39 eines Durchbruches 28, 29, 30 bzw. 31 im Bereich des dort liegenden Verbindungsabschnittes 40 , 41, 42 bzw. 43, wobei es aber vollkommen unerheblich ist, welchen Verlauf die jeweilige Bruchzone aufweist. In den Figuren 3 und 4 ist eine solche Bruchzone 48 lediglich schematisch mit einer strichpunktierten Linie angedeutet. Das Wegbrechen eines Trägerbereiches 23, 24, 25 bzw. 26 kann aber auch mit der Hand, insbesondere mit einem Finger, erfolgen.

Durch die vorstehend beschriebene Ausbildung der Leiterplatte - bei der jeder Trägerbereich von der übrigen Leiterplatte ringsum umgeben ist und zwischen jedem Trägerbereich und der übrigen Leiterplatte ein den betreffenden Trägerbereich teilweise umschließender Durchbruch vorgesehen ist und jeder Trägerbereich über einen zwischen den beiden Enden jedes Durchbruches liegenden Verbindungsabschnitt der Leiterplatte mit der übrigen Leiterplatte verbunden ist - ist erreicht, daß jede Batterie in jeder beliebigen Anordnung an einer Leiterplatte angebracht werden kann, also auch in einer solchen Anordnung, daß beide Trägerbereiche für eine Batterie in einem zentralen Bereich einer Leiterplatte liegen, wie dies bei der Leiterplatte gemäß Fig. 2 auch tatsächlich der Fall ist, und daß bei in jeder solchen beliebigen Anordnung angebrachter Batterie die Trägerbereiche der Leiterplatte von der übrigen Leiterplatte auf einfache Weise weggebrochen werden können, um eine Batterie aus dem Rasierapparat entfernen zu können.

Bei dem Rasierapparat 1 gemäß Fig. 1 ist - wie aus den Figuren 2 und 3 ersichtlich ist - jeder Durchbruch 28, 29, 30 bzw. 31 quer zur Längserstreckung einer Batterie 12 bzw. 13 ausgerichtet. Dabei ist die Anordnung so gewählt, daß - wie dies in Fig. 3 für den Durchbruch 28 dargestellt ist - in Draufsicht auf die Leiterplatte 14 eine Symmetrielinie 49 eines Durchbruches 28, 29, 30 bzw. 31 und eine der Batterielängsachsen 12a und 13a sich überdecken. Bei der Leiterplatte 14 gemäss den Figuren 2, 3 und 4 sind weiters je die beiden Enden 32, 33 bzw. 34, 35 und 36, 37 bzw. 38, 39 von zwei Durchbrüchen 28 und 29 bzw. 30 und 31 einander zugewandt, die zwei Trägerbereiche 23 und 24 bzw. 25 und 26 teilweise begrenzen, mit denen die beiden Lötfahnen 19 und 20 bzw. 21 und 22 einer Batterie 12 bzw. 13 mittels je einer Lötverbindung 27 fest verbunden sind. Eine solche Ausbildung hat sich in der Praxis als besonders günstig erwiesen, weil dadurch ein besonders leichtes und rasches Entfernen einer Batterie von einer Leiterplatte und aus einem Gerät ermöglicht ist.

Wie aus den Figuren 2 und 3 ersichtlich ist, ist bei der Leiterplatte 14 gemäß den Figuren 2 und 3 jeder Durchbruch 28, 29, 30 bzw. 31 im wesentlichen C-förmig ausgebildet, weil sich dies in der Praxis als besonders günstig erwiesen hat. Hierbei ist jeder Trägerbereich 23, 24, 25 bzw. 26 rechteckförmig ausgebildet und besteht jeder Durchbruch 28, 29, 30 bzw. 31 aus geradlinig verlaufenden Durchbruchsabschnitten. Dies hat sich im Hinblick auf ein möglichst einfaches und gutes Anlöten der Lötfahnen an den Trägerbereichen als vorteilhaft erwiesen. Die Herstellung der Durchbrüche 28, 29, 30 und 31 kann vorteilhafterweise praktisch ohne zusätzlichen Aufwand beim Stanzen der Löcher für das Aufnehmen bzw. Hindurchführen der Anschlußdrähte der an einer Leiterplatte anzubringenden Bauteile erfolgen.

Ergänzend sei noch erwähnt, daß mittels jeder Lötverbindung 27 eine Lötfahne 19, 20, 21 bzw. 22 mit einer Leiterbahn 50 der Leiterplatte 14 mechanisch und elektrisch verbunden ist, wie dies aus Fig. 3 ersichtlich ist.

Bei der in Fig. 5 teilweise dargestellten Leiterplatte 14 eines Gerätes gemäß einem zweiten Ausführungsbeispiel der Erfindung sind die Trägerbereiche im wesentlichen ovalförmig ausgebildet, und die schlitzartigen Durchbrüche weisen entsprechend der Ovalform der Trägerbereiche einen ovalsektorförmigen Verlauf auf, wie dies für den Trägerbereich 23 und den Durchbruch 28 in Fig. 5 dargestellt ist.

Bei der in Fig. 6 teilweise dargestellten Leiterplatte 14 eines Gerätes gemäß einem dritten Ausführungsbeispiel der Erfindung weisen die Trägerbereiche eine an zwei gegenüberliegenden Seiten mit je einer Abflachung versehene Kreisform auf, und die schlitzartigen Durchbrüche weisen entsprechend der Form der Trägerbereiche einen im wesentlichen kreisringsektorförmigen Verlauf auf, wie dies in Fig. 6 für den Trägerbereich 23 und den Durchbruch 28 dargestellt ist.

Weitere Ausbildungsvarianten von Trägerbereichen und schlitzförmigen Durchbrüchen sind bei den beiden in den Figuren 7 und 8 teilweise dargestellten Leiterplatten 14 von zwei Geräten gemäß einem vierten und einem fünften Ausführungsbeispiel der Erfindung vorgesehen, wobei ebenso wie bei den Leiterplatten 14 gemäß den Figuren 2, 3, 4, 5 und 6 eine Symmetrielinie 49 eines Durchbruches 28, 29, 30 bzw. 31 und eine Batterielängsachse 12a bzw. 13a einer Batterie 12 bzw. 13 in Draufsicht auf die Leiterplatte 14 sich überdecken, wie dies in den Figuren 7 und 8 für den Durchbruch 28 dargestellt ist.

In den Figuren 9 und 10 sind zwei Leiterplatten 14 von zwei Geräten gemäß einem sechsten und einem siebenten Ausführungsbeispiel der Erfindung teilweise dargestellt, aus denen zwei weitere Ausführungsvarianten von Trägerbereichen und Durchbrüchen ersichtlich sind, bei denen in Draufsicht auf die Leiterplatte 14 eine Symmetrielinie 49 eines Durchbruches 28, 29, 30 bzw. 31 senkrecht zu einer Batterielängsachse 12a bzw. 13a einer Batterie 12 bzw. 13 verläuft, wie dies für den Durchbruch 28 dargestellt ist.

Bei allen Geräten, deren Leiterplatten 14 in den Figuren 5 bis 10 dargestellt sind, können die Batterien in jeder beliebigen Lage angeordnet werden und ist ein einfaches Entfernen der Batterien aus den Geräten gewährleistet.

Die Erfindung ist auf die vorstehend beschriebenen Ausführungsvarianten nicht beschränkt, da die Trägerbereiche einer Leiterplatte und die die Trägerbereiche teilweise umschließenden Durchbrüche auch andere Formen aufweisen können, als jene Formen, die in den vorstehend angeführten Ausführungsbeispielen beschrieben und dargestellt sind. Ein Trägerbereich bzw. der diesen Trägerbereich teilweise umschließende Durchbruch müssen keine spiegelsymmetrische Ausbildung aufweisen.

Auch kann ein Trägerbereich und der diesen Trägerbereich teilweise umschließende Durchbruch gegenüber einer Längsachse einer Batterie seitlich versetzt angeordnet sein. Auch können ein Trägerbereich und der diesen Trägerbereich teilweise umschließende Durchbruch, die beispielsweise zu einer Symmetrielinie spiegelsymmetrisch ausgebildet sind, eine gegenüber einer Längsachse einer Batterie um einen von 90° abweichenden Winkel winkelversetzte Lage aufweisen, wobei dann die Symmetrielinie des Trägerbereiches bzw. des diesen teilweise umschließenden Durchbruches mit der Längsachse einer Batterie in Draufsicht auf eine Leiterplatte einen von 90° abweichenden Winkel miteinander einschließen.

## Patentansprüche

1. Gerät (1) mit einer Leiterplatte (14) und mit mindestens einer an der Leiterplatte (14) angebrachten, zur Energieversorgung des Gerätes (1) vorgesehenen Batterie (12, 13,) die zwei Pole (15, 16, 17, 18) aufweist, die mit je einer Lötfahne (19, 20, 21, 22) versehen sind, die mit einem Trägerbereich (23, 24, 25, 26) oder Leiterplatte (14) mittels einer Lötverbindung (27) fest verbunden ist, wobei die Trägerbereiche (23, 24, 25, 26) der Leiterplatte (14) von der übrigen Leiterplatte (14) wegbrechbar sind, um die mindestens eine Batterie (12, 13) aus dem Gerät (1) entfernen zu können, dadurch gekennzeichnet, dass jeder Trägerbereich (23, 24, 25, 26) der Leiterplatte (14) von der übrigen Leiterplatte (14) ringsum umgeben ist und dass zwischen jedem Trägerbereich (23, 24, 25, 26) und der übrigen Leiterplatte (14) ein den betreffenden Trägerbereich (23, 24, 25, 26) teilweise umschliessender Durchbruch (28, 29, 30, 31) vorgesehen ist und dass jeder Trägerbereich (23, 24, 25, 26) über einen zwischen den beiden Enden jedes Durchbruches (28, 29, 30, 31) liegenden Verbindungsabschnitt (40, 41, 42, 43) der Leiterplatte (14) mit der übrigen Leiterplatte (14) verbunden ist, wobei jeder innerhalb eines Durchbruches(28, 29, 30, 31) liegende Trägerbereich (23, 24, 25, 26) im wesentlichen im Bereich eines Verbindungsabschnittes (40, 41, 42, 43) von der übrigen leiterplatte (1), vorzugsweise mit Hilfe eines Werkzeuges (44), wegbrechbar ist.

2. Gerät nach Anspruch 1, dadurch gekennzeichnet, dass jeder Durchbruch (28, 29, 30, 31; 28) im wesentlichen quer zur längserstreckung (12a, 13a) einer Batterie (12, 13; 12) ausgerichtet ist und dass je die beiden Enden (32, 33, 34, 35, 36, 37, 38, 39; 32, 33) von zwei Durchbruchen(28, 29, 30, 31; 28) einander zugewandt sind, die zwei Trägerbereiche(23, 24, 25, 26; 23) teilweise begrenzen, mit denen die beiden Lötfahnen (19, 20, 21, 22; 19) einer Batterie(12, 13; 12) mittels je einer Lötverbindung (27) fest verbunden sind (Fig. 2, 3, 4; 5; 6; 7; 8).

3. Gerät nach Anspruch 1 oder 2, dadurch gekennzeichnet, dass jeder Durchbruch (28, 29, 30, 31; 28) im wesentlichen C-förmig ausgebildet ist (Fig. 2, 3, 4; 5; 6; 8; 9; 10).

4. Gerät nach Anspruch 3, dadurch gekennzeichnet, dass jeder Trägerbereich (23, 24, 25, 26; 23) rechteckformig ausgebildet ist und dass jeder Durchbruch (28, 29, 30, 31; 28) aus geradlinig verlaufenden Durchbruchsabschnitten besteht. (Fig. 2, 3, 4; 9).

## Claims

1. An apparatus (1) having a printed circuit board (14) and at least one battery (12, 13) mounted on the printed circuit board (14), which battery is intended for powering the apparatus (1) and has two terminals (15, 16, 17, 18), each provided with a solder lug (19, 20, 21, 22) which is fixedly connected to a mounting portion (23, 24, 25, 26) of the printed circuit board (14) by means of a solder joint (27), which mounting portions (23, 24, 25, 26) of the printed circuit board (14) can be severed from the remainder of the printed circuit board (14) to enable the at least one battery (12, 13) to be removed from the apparatus (1), characterized in that each mounting portion (23, 24, 25, 26) of the printed circuit board (14) is surrounded by the remainder of the printed circuit board (14), and an opening (28, 29, 30, 31) is formed between each mounting portion (23, 24, 25, 26) and the remainder of the printed circuit board (14), which opening partly surrounds the relevant mounting portion (23, 24, 25, 26), and each mounting portion (23, 24, 25, 26) is connected to the remainder of the printed circuit board (14) by a connecting portion (40, 41, 42, 43) of the printed circuit board (14), which connecting portion is situated between the two ends of each opening (28, 29, 30, 31), which mounting portions (23, 24, 25, 26), which are each situated within an opening (28, 29, 30, 31), can each be severed from the remainder of the printed circuit board (14) substantially at the location of a connecting portion (40, 41, 42, 43), preferably by means of a tool (44).

2. An apparatus as claimed in Claim 1, characterized in that each opening (28, 29, 30, 31; 28) extends transversely of the longitudinal axis (12a, 13a) of a battery (12, 13; 12), and the two ends (32, 33, 34, 35, 36, 37, 38, 39; 32, 33) of two openings (28, 29, 30, 31; 28) each time face one another, which openings partly bound two mounting portions (23, 24, 25, 26; 23) to which the two solder lugs (19, 20, 21, 22; 19) of a battery (12, 13; 12) are each fixedly connected by means of a solder joint (27) (Figs. 2, 3, 4; 5; 6; 7; 8).

3. An apparatus as claimed in Claim 1 or 2, characterized in that each opening (28, 29, 30, 31; 28) is substantially C-shaped (Figs. 2, 3, 4; 5; 6; 8; 9; 10).

4. An apparatus as claimed in Claim 3, characterized in that each mounting portion (23, 24, 25, 26; 23) is rectangular in shape, and each opening (28, 29, 30, 31; 28) consists of straight parts (Figs. 2, 3, 4; 9).

## Revendications

1. Appareil (1) avec une carte à circuit imprimé (14) et avec au moins une batterie (12, 13) prévue en vue de l'alimentation électrique de l'appareil (1) et appliquée contre la plaque à circuit imprimé (14) qui présente deux pôles (15, 16, 17, 18) qui sont respectivement dotés d'une lame à braser (19, 20, 21, 22) fixée à demeure à une zone de support (23, 24, 25, 26) de la carte à circuit imprimé (14) à l'aide d'une liaison par brasage (27), les zones de support (23, 24, 25, 26) dans la carte à circuit imprimé (14) pouvant être séparées du reste de la carte à circuit imprimé (14) pour pouvoir enlever au moins une batterie (12, 13) de l'appareil (1), caractérisé en ce que chaque zone de support (23, 24, 25, 26) de la carte à circuit imprimé (14) est entourée par le reste de la carte à circuit imprimé (14) et qu'entre chaque zone de support (23, 24, 25, 26) et le reste de la carte à circuit imprimé (14) il est prévu un orifice traversant (28, 29, 30, 31) entourant en partie la zone de support correspondante (23, 24, 25, 26) et que chaque zone de support (23, 24, 25, 26) est reliée par l'intermédiaire d'une section de liaison (40, 41, 42, 43) de la carte à circuit imprimé (14) située entre les deux extrémités de chaque orifice traversant (28, 29, 30, 31) avec le reste de la carte à circuit imprimé (14), chaque zone de support (23, 24, 25, 26) située à l'intérieur d'un orifice traversant (28, 29, 30, 31) pouvant être séparée essentiellement dans la région d'une section de liaison (40, 41, 42, 43) du reste de la carte à circuit imprimé (14), de préférence à l'aide d'un outil (44).

2. Appareil selon la revendication 1, caractérisé en ce que chaque orifice traversant (28, 29, 30, 31; 28) est orienté essentiellement de manière perpendiculaire à la direction longitudinale (12a, 13a) d'une batterie (12, 13; 12) et que les deux extrémités (32, 33, 34, 35, 36, 37, 38, 39; 32, 33) de deux orifices traversants (28, 29, 30, 31; 28) sont respectivement tournées l'une vers l'autre et délimitent en partie les deux zones de support (23, 24, 25, 26; 23) par lesquelles les deux lames à braser (19, 20, 21, 22; 19) d'une batterie (12, 13; 12) sont reliées à l'aide de respectivement une liaison par brasage (27) (Fig. 2, 3, 4; 5; 6; 7; 8).

3. Appareil selon la revendication 1 ou 2, caractérisé en ce que chaque orifice traversant (28, 29, 30, 31; 28) est essentiellement conçu en forme de C (Fig. 2, 3, 4; 5; 6; 8; 9; 10).

4. Appareil selon la revendication 3, caractérisé en ce que chaque zone de support (23, 24, 25, 26; 23) est de conception rectangulaire et que chaque orifice traversant (28, 29, 30, 31; 28) se compose de sections d'orifice traversant s'étendant linéairement (Fig. 2, 3, 4; 9).
